Europäisches Patentamt

European Patent Office

Office européen des brevets

(11) Publication number: **0 060 785**
**B1**

(12) **EUROPEAN PATENT SPECIFICATION**

(45) Date of publication of patent specification: **09.04.86**

(51) Int. Cl.⁴: **H 01 L 21/316, H 01 L 21/324**

(21) Application number: **82400450.1**

(22) Date of filing: **12.03.82**

(54) Method of inducing flow or densification of phosphosilicate glass for integrated circuits.

(30) Priority: **16.03.81 US 243990**

(43) Date of publication of application:
**22.09.82 Bulletin 82/38**

(45) Publication of the grant of the patent:
**09.04.86 Bulletin 86/15**

(84) Designated Contracting States:
**DE FR GB IT NL**

(56) References cited:
**GB-A-2 023 342**

(73) Proprietor: **FAIRCHILD CAMERA &
INSTRUMENT CORPORATION
464 Ellis Street
Mountain View California 94042 (US)**

(72) Inventor: **Razouk, Reda
1419 Pointe Claire Court
Sunnyvale California 94087 (US)**

(74) Representative: **Chareyron, Lucien et al
Schlumberger Limited Service Brevets c/o Giers
12, place des Etats Unis B.P. 121
F-92124 Montrouge Cédex (FR)**

Courier Press, Leamington Spa, England.

## Description

### Background of the Invention

*Field of the Invention*

This invention relates to the reflow or densification of glasses commonly employed as insulation and passivation layers in integrated circuits and particularly to methods of inducing flow or densification of these glasses.

*Description of the Prior Art*

Presently, phosphorus doped silicon oxide glasses (known as "phosphosilicate" glasses) are used in integrated circuits as insulation between the silicon material and integrated circuit leads and as insulation between various levels of conductive leads formed on integrated circuits containing multiple layers of conductive leads. In order to reduce the frequency of occurrence of cracks and breaks in the lead pattern resulting from steps in the height of the glass film, the glass film is heated to reflow and smooth out the steps. Typically, a phosphosilicate glass film comprises a chemical vapor deposited oxide of silicon doped with approximately 7% to 9% by weight of phosphorus. This film is formed in a well-known manner in a "CVD" reactor using chemical vapor deposition techniques involving an inert ambient or an ambient containing phosphorus dopant. In the latter case, the deposition of the glass film is carried out selectively in order to selectively dope with phosphorus some areas of the semiconductor material to comprise active regions of the device. The presence of phosphorus dopants in this situation is not directly related to the flow process to redistribute and smooth out the glass.

The main shortcoming of the prior art is that the structure must be heated to in excess of 1000°C in order to flow and densify the phosphosilicate glass. These elevated temperatures cause the dopants in the underlying semiconductor material to redistribute. Such redistribution is particularly undersirable and intolerable in the smaller and more advanced VLSI (very large scale integration) devices now being developed where a small amount of redistribution causes a substantial change in device characteristics. The flow of phosphosilicate glass is discussed in a paper entitled "Phosphosilicate Glass Flow for Integrated Optics" by A. Naumaan and J. T. Boyd in the Journal of Vacuum Science Technology, January/February 1980. In addition, the flow of phosphosilicate glass in a steam-containing atmosphere is disclosed in U.K. patent GB—A—2023342.

### Summary of the Invention

In accordance with this invention, the flow of deposited phosphosilicate glasses is achieved at a temperature substantially beneath that commonly used in the prior art by use of a selected ambient at a high pressure. The use of the higher pressure substantially reduces the temperature at which the phosphosilicate glass reflows thereby substantially reducing the redistribution of dopant in the underlying semiconductor material.

### Description of the Drawings

Figure 1 illustrates a cross-section of a region of a semiconductor wafer (11) beneath a contact opening to polycrystalline silicon (12) underlying phosphosilicate glass (13) and with a via (15) cut through the phosphosilicate glass (13) to the underlying polycrystalline silicon (12) before reflow.

Figure 2 illustrates the structure of Figure 1 after reflow and shows the more gentle, curved nature of the sides (15b) of the via (15) after reflow.

Figure 3 is a graph showing the variation of time to flow as a function of temperature for 25 atmospheres pressure and one (1) atmosphere pressure.

Figure 4 shows the time to flow as a function of the percentage of moisture in the atmosphere in which the integrated circuit is placed for heating to obtain reflow of glass.

### Detailed Description of the Invention

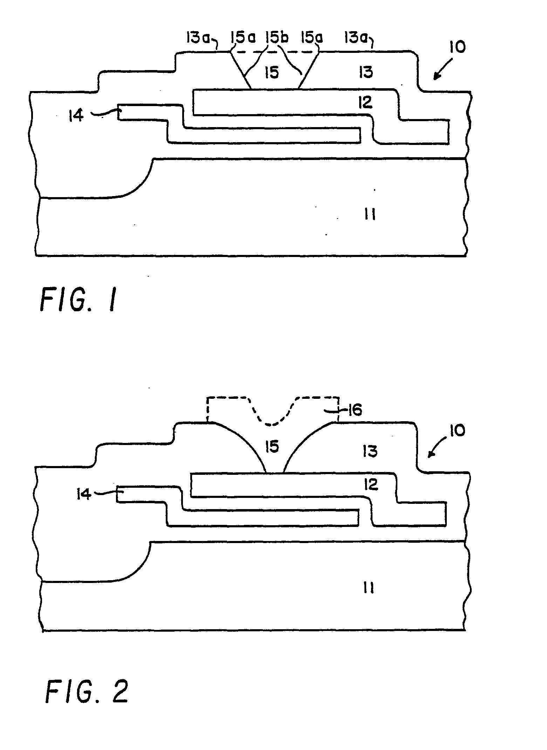

A semiconductor structure commonly employed is shown in Figure 1. Figure 1 illustrates a cross-section of a semiconductor device comprising a silicon substrate 11 on which is formed in a well-known manner an insulation layer 20 (typically silicon dioxide). A floating polycrystalline silicon conductive gate 14 is formed in a well-known manner and polycrystalline silicon 12 is formed above but insulated from a portion of floating gate 14. Phosphosilicate glass 13 is then formed above polycrystalline silicon gate 14 as shown, by a well-known process.

Via or contact open 15 is then formed in phosphosilicate glass 13 typically using a well-known hydrofluoric acid etch to expose a portion of the top surface of polycrystalline silicon 12. The edge 15a of sidewall 15b with top surface 13a is shown to be sharp and sidewall 15b is shown relatively steep relative to the top surface of polycrystalline silicon 12 and the top surface 13a of phosphosilicate glass 13. Device 10, as illustrated, typically could comprise a portion of an EPROM, for example.

Figure 2 shows the structure of Figure 1 after the device has been heated to a temperature sufficient to soften, or flow, the phosphosilicate glass 13 so as to round off edge 15a and thus allow the formation of a contact 16 to the exposed portion of the top surface of polycrystalline silicon gate 12. Contact 16 typically is of aluminum or metal. In the prior art, the flow of the phosphosilicate glass and the softening of the edge 15a and reduction of the slope of the sides 15b was done by heating the structure to a temperature of approximately 1000°C in a dry ambient. This caused the dopants within the semiconductor material 11 to further distribute and thereby changed the characteristics of the device in an undesirable manner.

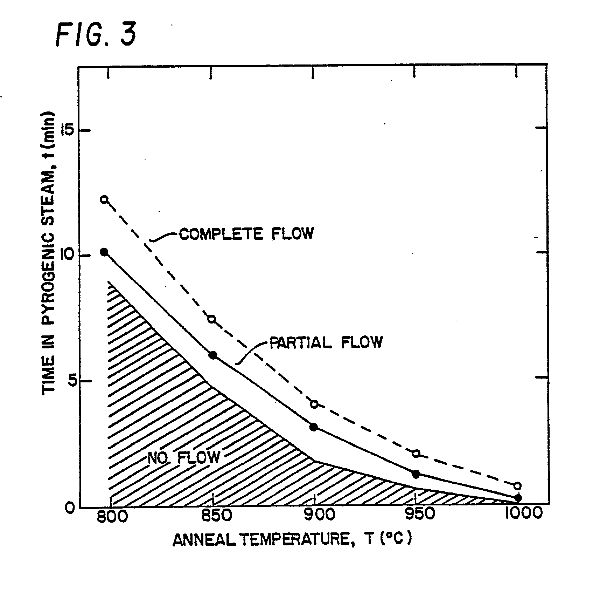

The method of this invention involves heating the device 10 under pressure in an inert ambient containing moisture or in a steam ambient to achieve flow of the glass at a temperature lower than that possible at one atmosphere. Figure 3 illustrates this invention. Figure 3 comprises a graph of time to flow a phosphosilicate glass such as glass layer 13 shown in Figures 1 and 2 versus the temperature in degrees centigrade at which the glass flows. At 25 atmospheres pressure in a steam or wet environment, the phosphosilicate glass 13 flows at 800°C in about 12 minutes. As the time to flow is decreased, the temperature to which the structure must be heated (at 25 atmospheres) increases as shown by the graph. The subjection of the semiconductor device of Figures 1 and 2 to an 800°C temperature for 12 minutes does not materially affect the dopant profiles within the device structure but does allow the phosphosilicate glass 13 to flow so that the device structure as shown in Figure 1 becomes similar in cross-section to the structure shown in Figure 2. The sharp edges 15a shown in Figure 1 have been rounded as shown in Figure 2 at temperatures sufficiently low that little or no dopant redistribution occurs in the underlying substrate 11. Thus, in accordance with this invention the temperature at which flow of phosphosilicate glass is obtained is reduced at least 100°C or more while the heating time of the device remains the same.

In contrast, prior art methods of flowing glass at one (1) atmosphere pressure require that device 10 be subjected to, for example, a temperature of 900°C for 44 minutes. If temperatures slightly lower than 900°C are used at one (1) atmosphere pressure, the time required for glass flow is increased from 44 minutes. Temperatures in excess of 900°C require only slightly less time than 44 minutes for the glass to flow. Subjecting device 10 to such temperatures for the substantially greater time required to cause the glass to flow utilizing prior art methods at one (1) atmosphere pressure does cause further diffusion of dopants, thus causing an undesired change in the dopant profiles.

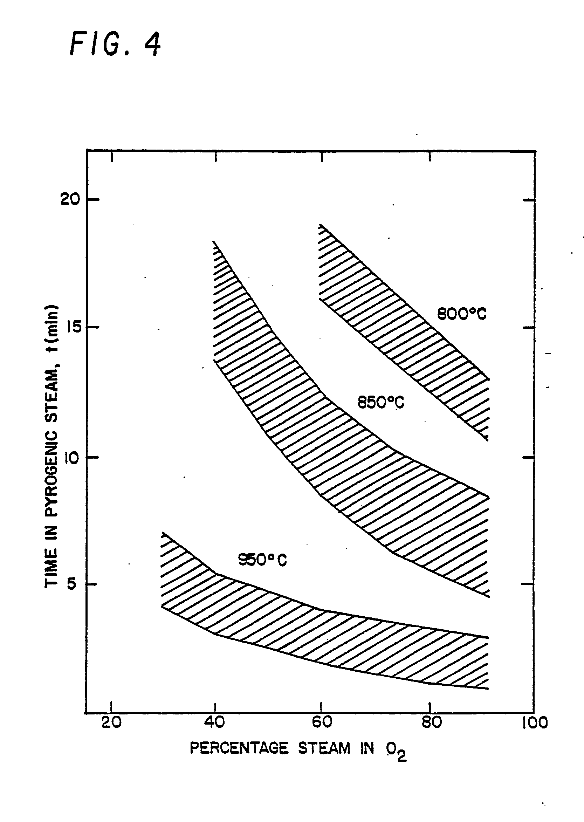

Experiments show that the water content of the ambient plays a critical role in the process. Experiments also show that the time to flow the phosphosilicate glass is a function of the percentage of moisture in the ambient. As the moisture content increases from approximately 40% to 100%, the time to flow decreases as shown by the curve in Figure 4.

Experiments also show that moisture must be present in the ambient to achieve the results shown in Figure 3. When raw silicon is exposed to a moist atmosphere at these pressures the silicon oxidizes. However, the solution to this problem is to process the wafer at a high pressure, in accordance with this invention, prior to completely forming the contact holes.

The variables which must be controlled in implementing the process of this invention are pressure, temperature and moisture content of the ambient. Experiments have shown that the phosphorus content over a reasonable range has no effect on the results. Thus, a low phosphorus content phosphosilicate glass containing about 6% phosphorus by weight in the glass will reflow in approximately the same time as a phosphosilicate glass containing a higher percentage phosphorus content. Reducing the steam content of the ambient increases the time to flow the phosphosilicate glass. Experiments have shown that three different flow regimes are obtained depending upon the ambient, the temperature, the pressure and the time. These three regimes are characterized as "no flow", "intermediate flow" and "full flow". In intermediate flow, the sharp edge boundary can just be discerned in the structure but sufficient flow has occurred to allow a contact to be made over the edge and down into the contact region without significant danger of cracking. Full flow removes any remainder of the sharp edge boundary.

By increasing the pressure, the temperature is further reduced for a given amount of flow.

Ambients suitable for use with this invention include nitrogen and argon. Using wet nitrogen with 2 to 3 parts per million of water moisture is also adequate to achieve the results of the type shown in Figure 3. Experiments show that phosphosilicate glass, even at atmospheric pressure, flows more easily if there is moisture in the atmosphere. The experiments show that the flow is invariant between about 6% to 9% of phosphorus content by weight in the phosphosilicate glass.

The pressure at which the reflow of the phosphosilicate glass 13 (Figure 1) is obtained at a temperature below about 550°C is important. At this pressure, the aluminum will not melt thereby allowing the reflow of glass in conjunction with phosphosilicate glass/aluminum interconnect systems. This greatly simplifies the processing of semiconductor devices. At high pressures, the melting temperature of aluminum increases while the reflow temperature of the phosphosilicate glass decreases thereby providing a glass-metal system which is inherently compatible with the high pressure flow techniques of this invention.

## Claims

1. The method of flowing a phosphorus doped silicon oxide (hereinafter "phosphosilicate glass") glass which comprises:

raising the pressure of said phosphosilicate glass above atmospheric pressure for a selected period of time; and

heating said phosphosilicate glass to a selected temperature sufficient to cause said glass to flow at said pressure, said selected temperature being less than the temperature at which said phosphosilicate glass will flow at atmospheric pressure.

2. The method of Claim 1 wherein said phosphosilicate glass is raised to a selected pressure above ambient in an environment comprising moisture.

3. The method of Claim 1 wherein said phosphosilicate glass is raised to a selected pressure above ambient in an environment comprising moisture and oxygen.

4. The method of Claim 1 wherein said phosphosilicate glass is raised to a selected pressure above ambient in an environment comprising moisture and inert gas.

5. The method of Claim 2, 3 or 4 wherein said phosphosilicate glass is raised to pressure sufficient that said phosphosilicate glass flows at a temperature less than 1000°C.

6. The method of Claim 1 wherein said phosphosilicate glass is raised to a pressure within a range of pressures sufficient that said phosphosilicate glass flows at a temperature within the range of 750°C to 1000°C.

7. The method of Claim 6 wherein said phosphosilicate glass is raised to a pressure of approximately 25 atmospheres in an environment comprising moisture.

8. The method of Claim 6 wherein said phosphosilicate glass is raised to a pressure of approximately 25 atmospheres in an environment comprising moisture and oxygen.

9. The method of Claim 6 wherein said phosphosilicate glass is raised to a pressure of approximately 25 atmospheres in an environment comprising moisture and an inert gas.

10. The product made by the process of Claims 1, 2, 3, 4, 6, 7, 8 or 9.

11. The product made by the process of Claim 5.

## Revendications

1. Procédé pour l'écoulement d'un verre d'oxyde de silicium dopé au phosphore (appelé ci-après "verre au phosphosilicate") qui comprend les étapes suivantes:

augmenter la pression dudit verre au phosphosilicate au-dessus de la pression atmosphérique pendant une période de temps sélectionnée; et

chauffer ledit verre au phosphosilicate jusqu'à une température sélectionnée suffisante pour faire couler ledit verre à ladite pression, ladite température sélectionnée étant inférieure à celle à laquelle ledit verre au phosphosilicate coule à la pression atmosphérique.

2. Procédé selon la revendication 1, dans lequel ledit verre au phosphosilicate est élevé à une pression sélectionnée au-dessus de la pression ambiante dans un environnement contenant de l'humidité.

3. Procédé selon la revendication 1, dans lequel ledit verre au phosphosilicate est élevé à une pression sélectionnée au-dessus de la pression ambiante dans un environnement contenant de l'humidité et de l'oxygène.

4. Procédé selon la revendication 1, dans lequel ledit verre au phosphosilicate est élevé à une pression sélectionnée au-dessus de la pression ambiante dans un environnement contenant de l'humidité et un gaz inerte.

5. Procédé selon la revendication 2, 3 ou 4, dans lequel ledit verre au phosphosilicate est élevé à une pression suffisante pour qu'il coule à une température inférieure à 1000°C.

6. Procédé selon la revendication 1, dans lequel ledit verre au phosphosilicate est élevé à une pression comprise dans une plage suffisante pour que ledit verre au phosphosilicate coule à une température comprise dans une plage allant de 750°C à 1000°C.

7. Procédé selon la revendication 6, dans lequel ledit verre au phosphosilicate est élevé à une pression d'environ 25 atmosphères dans un environnement contenant de l'humidité.

8. Procédé selon la revendication 6, dans lequel ledit verre au phosphosilicate est élevé à une pression d'environ 25 atmosphères dans un environnement contenant de l'humidité et de l'oxygène.

9. Procédé selon la revendication 6, dans lequel ledit verre au phosphosilicate est élevé à une pression d'environ 25 atmosphères dans un environnement contenant de l'humidité et un gaz inerte.

10. Produit réalisé par la procédé des revendications 1, 2, 3, 4, 6, 7, 8 ou 9.

11. Produit réalisé selon le procédé de la revendication 5.

## Patentansprüche

1. Verfahren zum Fließenlassen eines phosphorgedopten Siliziumoxidglases (nachstehend "Phosphorsilicatglas"), welches umfaßt:

Erhöhen des Drucks des besagten Phosphorsilicatglases über atmosphärischen Druck für eine ausgewählte Zeitspanne; und

Erhitzen des Phosphorsilicatglases auf eine ausgewählte Temperatur, ausreichend um zu bewirken, daß das besagte Glas bei dem besagten Druck fließt, wobei die ausgewählte Temperatur geringer als die Temperatur ist, bei der das besagte Phosphorsilicatglas bei atmosphärischem Druck fließt.

2. Verfahren nach Anspruch 1, wobei das besagte Phosphorsilicatglas auf einen ausgewählten Druck über Umgebungsdruck in einer Feuchtigkeit enthaltenden Umgebung angehoben wird.

3. Verfahren nach Anspruch 1, wobei das besagte Phosphorsilicatglas auf einen ausgewählten Druck über Umgebungsdruck in einer Umgebung enthaltend Feuchtigkeit und Sauerstoff angehoben wird.

4. Verfahren nach Anspruch 1, wobei das besagte Phosphorsilicatglas auf einen ausgewählten Druck über Umgebungsdruck in einer Feuchtigkeit und Inertgas enthaltenden Umgebung angehoben wird.

5. Verfahren nach Anspruch 2, 3 oder 4, wobei das besagte Phosphorsilicatglas auf einen Druck angehoben wird, der ausreichend ist, damit das besagte Phosphorsilicatglas bei einer Temperatur geringer als 1000°C fließt.

6. Verfahren nach Anspruch 1, wobei das besagte Phosphorsilicatglas auf einen Druck innerhalb eines Druckbereichs angehoben wird, der ausreichend ist, damit das besagte Phosphorsilicatglas bei einer Temperatur im Bereich von 750° bis 1000°C fließt.

7. Verfahren nach Anspruch 6, wobei das besagte Phosphorsilicatglas auf einen Druck von ungefähr 25 Atmosphären in einer Feuchtigkeit enthaltenden Umgebund angehoben wird.

8. Verfahren nach Anspruch 6, wobei das besagte Phosphorsilicatglas auf einen Druck von ungefähr 25 Atmosphären in einer Feuchtigkeit und Sauerstoff enthaltenden Umgebung angehoben wird.

9. Verfahren nach Anspruch 6, wobei das besagte Phosphorsilicatglas auf auf einen Druck von ungefähr 25 Atmosphären in einer Feuchtigkeit und Inertgas enthaltenden Atmosphäre angehoben wird.

10. Produkt, hergestellt mit dem Verfahren nach Anspruch 1, 2, 3, 4, 6, 7, 8 oder 9.

11. Produkt, hergestellt mit dem Verfahren nach Anspruch 5.

FIG. 1

FIG. 2

FIG. 3

FIG. 4